# DEMANDE DE BREVET EUROPEEN

(11) **EP 1 288 343 A2**
(43) Date de publication de la demande: **05.03.2003**
(21) Numéro de dépôt: 02292084.7
(22) Date de dépôt: 22.08.2002
(51) Int. Cl.: C30B 11/00

(54) **Electrode massive pour une cartouche de solidification de deux charges liquides**

(30) Priorité: 24.08.2001 FR 0111095
(71) Demandeur: COMMISSARIAT A L'ENERGIE ATOMIQUE, 75752 Paris Cedex 15 (FR); CENTRE NATIONAL D'ETUDES SPATIALES, 75001 Paris (FR)
(72) Inventeur: Salvi, Charles, 38000 Grenoble (FR); Garandet, Jean-Paul, 38000 Grenoble (FR); Borgis, André, 38000 Grenoble (FR)
(74) Mandataire: Ilgart, Jean-Christophe

(57) **Abrégé**

Une électrode (19) passive de jonction électrique entre deux portions liquides (9 et 10) de charges à solidifier progressivement dans un creuset a un caractère massif qui lui permet de mieux égaliser la température des zones de contact des charges et donc de diminuer l'effet thermoélectrique produit à l'électrode (19), qui perturbe un contrôle de qualité de la solidification entrepris avec deux électrodes (15, 16) de mesure disposées à l'autre extrémité des charges. L'invention s'applique à la cristallogenèses et à son contrôle.

## Description

L'invention a trait à une cartouche de solidification de deux charges liquides, et son domaine est avant tout la croissance de corps tels que des cristaux par solidification progressive d'une charge versée à l'état liquide dans un creuset.

Les appareils existants comprennent en général une cartouche composée principalement d'un creuset évidé d'au moins un alvéole dans lequel une charge à solidifier est versée, ainsi qu'un four entourant le creuset et mobile par rapport à lui. Pour solidifier la charge, on dégage une longueur toujours plus importante du creuset en reculant progressivement le four et laissant la charge présente dans cette longueur se refroidir. Une précaution usuelle consiste à déposer un germe ayant la structure cristalline recherchée à l'extrémité de l'alvéole qui est dégagé en premier par le four. Ainsi, la charge solidifiée croît à partir du germe en imitant sa structure cristalline.

Un problème communément rencontré, notamment avec les corps enrichis d'un dopant, est de contrôler la composition des sections de la charge qui se solidifient successivement, afin de vérifier qu'elles gardent la bonne composition cristalline demandée. Un procédé de contrôle satisfaisant porte le nom de Seebeck et comporte quelques variantes. I1 est fondé sur les propriétés thermodynamiques des mélanges mis à solidifier et sur l'exploitation d'un phénomène thermoélectrique.

Un mélange se solidifie à une température qui dépend de la composition de la fraction se solidifiant. Si on ajoute une charge servant de témoin dans un autre alvéole à côté de la charge principale, se solidifiant avec elle et ayant une composition connue avec certitude, telle que le corps de base de la charge principale à l'état pur, une mesure indirecte de la température de solidification de la charge principale devient possible en disposant deux électrodes sur les portions solidifiées des charges, en mesurant la différence de potentiel entre ces électrodes dans un circuit qui les relie, et en rapportant cette différence de potentiel à des résultats d'étalonnage. Quelques dispositions supplémentaires doivent être prises. C'est ainsi que les parties liquides des charges doivent être au même potentiel, ce qu'on accomplit en disposant une électrode supplémentaire, passive, qui joint les alvéoles en baignant les parties liquides des charges. De plus, les électrodes de mesure et les portions adjacentes des parties solidifiées des charges doivent être à la même température sous peine de produire un effet thermoélectrique supplémentaire qui modifierait la différence de potentiel à mesurer et brouillerait la mesure. C'est pourquoi les électrodes et les extrémités des charges solidifiées sortent du creuset et sont logées dans un système homogénéisateur de température en matière conductrice thermique et en contact avec les extrémités des charges et les électrodes, ce qui égalise leurs températures. Un dispositif actif d'égalisation peut être ajouté : il prend la forme, par exemple, d'une ou plusieurs spires de chauffage entourant la matière de l'homogénéisateur, ou de moyens indépendants de chauffage ou de refroidissement des extrémités des charges.

Malgré ces précautions, le signal de mesure est faible et facilement brouillé par des phénomènes adventices. Nous pensons notamment aux effets thermoélectriques indésirables produits aux jonctions de milieux différents dans le circuit constitué entre les électrodes de mesure et comprenant les charges. Or de tels effets thermoélectriques apparaissent d'autant plus facilement que ce circuit est soumis à des variations de température très marquées.

Un effet thermoélectrique se manifeste ainsi entre l'électrode passive et les portions liquides de la charge qu'elle baigne. Comme ces portions sont normalement à des températures différentes, les effets thermoélectriques produits aux deux bouts de l'électrode sont différents et ne s'annulent pas. Les différentes réalisations d'électrodes dans l'art antérieur sont toutes sujettes à cet inconvénient. On peut les distinguer en deux genres principaux : des plaquettes assez minces encastrées dans une communication entre les alvéoles et fermant cette communication, les charges liquides n'étant séparées que par la plaquette ; ou des aigrettes serties dans un bouchon engagé dans la communication et dont les deux bouts sortent du bouchon pour pointer vers les alvéoles contenant les charges. D'une façon générale, ces électrodes sont difficiles à enchâsser dans le creuset, et ne garantissent ni une symétrie de contact avec les deux charges, qui serait une condition préalable à une égalisation et une annulation des effets thermoélectriques, ni la séparation étanche des charges, en raison des risques importants de défauts de montage de l'électrode dans la communication. C'est pourquoi un perfectionnement, qui constitue le sujet de cette invention, est souhaité et proposé ici.

L'invention est relative à une cartouche de solidification de deux charges liquides, comprenant un creuset à deux alvéoles pour les charges et une électrode formée d'un conducteur électrique joignant les charges, caractérisée en ce que le conducteur est massif et s'étend au-delà des alvéoles dans une direction d'extension coupant une direction d'alignement des alvéoles et s'étendant entre les alvéoles.

Le caractère massif et l'allongement de l'électrode assurent une meilleure conduction de la chaleur, une uniformisation beaucoup plus grande de la température de l'électrode et une égalisation corrélative des températures des charges liquides devant cette électrode. D'autre part, il est facile d'obtenir une symétrie parfaite des contacts entre l'électrode et les charges. Les effets thermoélectriques produits entre l'électrode et les charges sont alors à la fois faibles et sensiblement égaux : ils se compensent et n'ont plus d'effet sur la mesure.

L'électrode peut être une barrette cylindrique disposée dans un logement qu'on peut opérer par un perçage diamétral complet du creuset. La barrette est alors installée en l'emmanchant dans ce perçage. Le procédé est particulièrement simple. La simplicité des formes cylindriques permet de garantir un ajustement étanche quand la barrette a été emmanchée.

Un autre perfectionnement proposé ici est surtout sensible quand les charges contiennent de l'étain. Les électrodes employées jusqu'à présent sont en carbone, qui mouille mal l'étain, ou en tungstène, qui réagit chimiquement avec lui. D'autres corps auxquels on pourrait penser comportent aussi ces problèmes, mais après certains essais, il a cependant été trouvé que le rhénium était impeccable pour constituer l'électrode pour des charges en étain ou d'ailleurs en d'autres matériaux.

L'invention sera maintenant décrite en liaison aux figures :

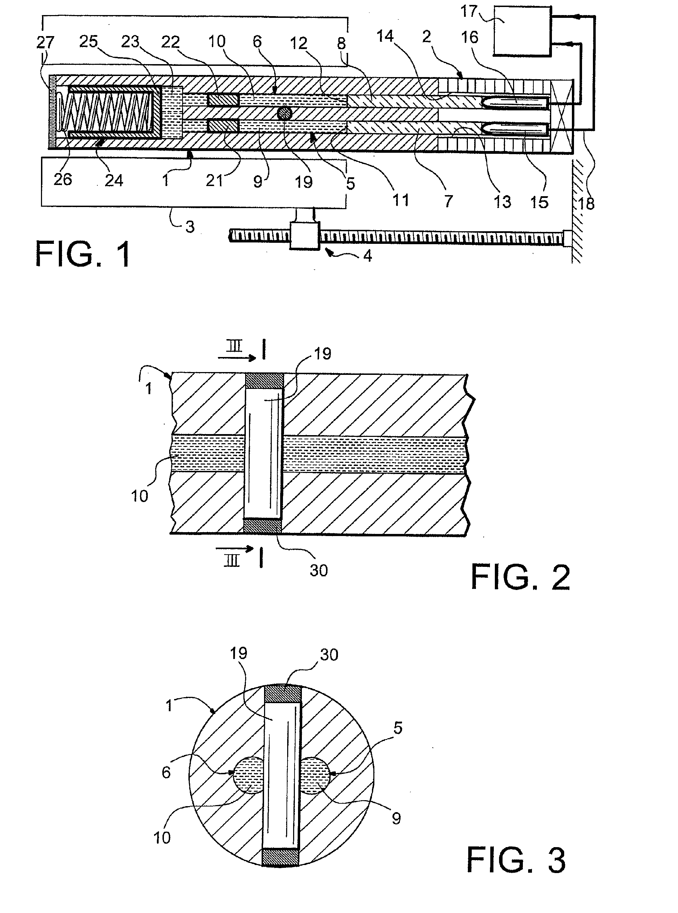

- la figure 1 est une vue générale d'un four de solidification, et
- les figures 2 et 3 sont deux vues en détail de l'électrode, dans deux coupes perpendiculaires à celle de la figure 1.

Un four de solidification comprend un creuset 1 élancé prolongé par un dispositif homogénéisateur 2 de température. Un four 3 entoure une portion du creuset 1 et se déplace en le dégageant progressivement à partir de régions proches de l'homogénéisateur 2 pendant le processus de solidification. I1 peut à cet effet être uni à un support fixe par un dispositif de liaison 4 comprenant une glissière, une vis sans fin ou tout autre moyen analogue. Le mouvement de dégagement du four 3 est assuré par un dispositif de commande non représenté.

Le creuset 1 comprend deux alvéoles 5 et 6 longitudinaux et parallèles pour une charge principale et une charge de référence qu'on solidifie. Les charges comprennent chacune une portion solidifiée 7 ou 8 et une portion liquide 9 ou 10 séparées par une interface 11 ou 12 pouvant être à des endroits différents. Les portions solidifiées 7 et 8 sortent des alvéoles 5 et 6 pour pénétrer dans des alvéoles 13 et 14 de l'homogénéisateur 2 qui prolongent respectivement les précédents. Deux électrodes 15 et 16 en pointe s'étendent aux bouts des alvéoles 13 et 14 et sont reliées à un dispositif de mesure de tension 17 par un circuit électrique 18 qui les unit. De plus, une électrode 19 passive s'étend dans la masse du creuset 1, entre les alvéoles 5 et 6 de manière à y déboucher et à baigner les portions liquides 9 et 10. L'homogénéisateur 2 est en général un bloc de matière conductrice de chaleur pour porter les extrémités des portions solidifiées 7 et 8 à une même température, comme on l'a mentionné. On ne s'étendra pas sur sa description, qui ne regarde pas cette invention, et on se consacrera désormais aux éléments constitutifs de celle-ci.

Deux pistons 21 et 22 glissent à l'arrière des alvéoles 5 et 6 pour confiner les portions liquides 9 et 10. Derrière eux s'étend une masse liquide 23 qui occupe le reste des alvéoles 5 et 6 ainsi qu'une partie adjacente d'un logement cylindrique 24 évidé tout à l'arrière du creuset 1 et dans lequel débouchent les deux alvéoles 5 et 6. La masse liquide 23 est confinée dans une partie du logement 24 par un plateau de compression 25 repoussé par un ressort 26 comprimé entre ce plateau 25 et un couvercle 27 du logement 24, qui est assujetti au creuset 1.

Conformément à l'invention, l'électrode 19 passive est une barrette cylindrique à section circulaire faite de rhénium et engagée dans un perçage 30 de section correspondante du creuset 1. Le perçage 30 est diamétral dans le creuset 1 et s'étend de façon sécante à une direction d'alignement des alvéoles 5 et 6, tout en passant entre eux. Comme le diamètre du perçage 30 est un peu supérieur à l'écart entre les alvéoles 5 et 6, il établit une communication entre eux, que l'électrode 19 interrompt dès qu'elle est posée. En pratique, elle est installée par un simple emmanchement à force, suffisant pour maintenir l'étanchéité. Le caractère massif de l'électrode 19, joint à son extension dans le perçage 30 bien au-delà des charges 9 et 10, permet d'y uniformiser la température beaucoup mieux qu'avec les conceptions antérieures. Enfin, les alvéoles 5 et 6 peuvent être rendus proches l'un de l'autre grâce à la qualité de l'étanchéité ce qui réduit encore le gradient thermique entre les zones de contact des charges.

## Revendications

1. Cartouche de solidification de deux charges liquides, comprenant un creuset (1) à deux alvéoles (5, 6) pour les charges et une électrode formée d'un conducteur électrique joignant les charges, **caractérisée en ce que** le conducteur (19) est massif et s'étend au-delà des alvéoles dans une direction d'extension coupant une direction d'alignement des alvéoles et s'étendant entre les alvéoles.

2. Cartouche de solidification de deux charges selon la revendication 1, **caractérisée en ce que** le conducteur est une barrette cylindrique disposée dans la direction d'extension.

3. Cartouche de solidification de deux charges selon l'une quelconque des revendications 1 ou 2, **caractérisée en ce que** le conducteur est en rhénium.
